**Europäisches Patentamt**

**European Patent Office**

**Office européen des brevets**

(11) Numéro de publication: **0 126 499**

**B1**

(12) # FASCICULE DE BREVET EUROPÉEN

(45) Date de publication du fascicule du brevet:
13.01.88

(51) Int. Cl.⁴: **H 01 L 21/76,** H 01 L 29/72,
H 01 L 21/74

(21) Numéro de dépôt: **84200427.7**

(22) Date de dépôt: **26.03.84**

(54) Procédé de réalisation d'un transistor bipolaire haute tension.

(30) Priorité: **30.03.83 FR 8305246**

(43) Date de publication de la demande:
**28.11.84 Bulletin 84/48**

(45) Mention de la délivrance du brevet:
**13.01.88 Bulletin 88/2**

(84) Etats contractants désignés:
**DE FR GB NL**

(56) Documents cité:
EP-A-0 017 021
EP-A-0 092 671
FR-A-2 290 039
FR-A-2 415 370
GB-A-1 309 502

**INTERNATIONAL ELECTRON DEVICES MEETING,
3-5 décembre 1979, Washington, D.C., pages 238-241, IEEE, New York, US; J.A. APPELS et al.: "High voltage thin layer devices (resurf devices)"
PATENTS ABSTRACTS OF JAPAN, vol. 5, no. 198, (E-87) 870 , 16 décembre 1981
IBM TECHNICAL DISCLOSURE BULLETIN, vol. 15, no. 1, juin 1972, page 288, New York, US; H.H. BERGER et al.: "Diffusion front tailoring"**

(73) Titulaire: **RTC- COMPELEC, 130, Avenue Ledru-Rollin, F-75011 Paris (FR)**

(84) Etats contractants désignés: **FR**

(73) Titulaire: **N.V. Philips' Gloeilampenfabrieken, Groenewoudseweg 1, NL- 5621 BA Eindhoven (NL)**

(84) Etats contractants désignés: **DE GB NL**

(72) Inventeur: **Vertongen, Bernard, SOCIETE CIVILE S.P.I.D. 209, rue de l'Université, F-75007 Paris (FR)**
Inventeur: **Vite, Jean- Louis, SOCIETE CIVILE S.P.I.D. 209, rue de l'Université, F-75007 Paris (FR)**

(74) Mandataire: **Pinchon, Pierre, Société Civile S.P.I.D. 209 rue de l'Université, F-75007 Paris (FR)**

LIBER, STOCKHOLM 1988

## Description

La présente invention concerne un procédé de réalisation d'un dispositif semiconducteur comportant au moins un transistor bipolaire haute tension, procédé selon lequel sur un substrat on dépose successivement une première couche épitaxique d'un premier type de conduction et une deuxième couche épitaxique du second type de conduction opposé au premier, on forme une zone de contact sur la deuxième couche épitaxique, on forme des cloisons latérales d'isolement du premier type de conduction, cloisons qui pénètrent dans la première couche épitaxique après avoir traversé la deuxième couche épitaxique, lesdites cloisons latérales entourant un caisson formé dans la deuxième couche épitaxique, l'épaisseur et la concentration de dopage de la deuxième couche étant telles que, en appliquant une tension inverse à la jonction pn entre d'une part la deuxième couche épitaxique, et d'autre part la première couche épitaxique et les cloisons d'isolement, la zone désertée engendrée par cette tension s'étende sur toute l'épaisseur de la deuxième couche épitaxique pour une valeur de ladite tension inférieure à la tension de claquage, la distance séparant les cloisons latérales d'isolement de la zone de contact étant supérieure à l'étendue latérale maximum de la zone désertée à partir des cloisons d'isolement dans la deuxième couche épitaxique.

La présente invention concerne également le dispositif obtenu par ce procédé.

Le procédé décrit ci-dessus est connu de FR-A-2 415 370.

On sait que dans les composants semiconducteurs bipolaires planaires de type classique sont formées des jonctions dites "actives" créées à partir de couches épitaxiques superposées de types de conduction alternés participant au fonctionnement desdits composants, et isolées dans un compartiment ou caisson.

Lorsqu'il s'agit de transistors haute tension, le problème de cet isolement, notamment l'isolement latéral, est très important et il est connu alors, pour améliorer les caractéristiques électriques de ces composants, de donner auxdites jonctions actives une structure plane. Pour ce faire, dans un premier temps, chaque caisson a donc été délimité latéralement à l'aide de gorges creusées à partir de la surface du corps semiconducteur portant lesdits transistors pour donner à ces derniers une configuration connue des spécialistes sous le nom de "mésa". Eventuellement et selon la valeur des tensions appliquées, la surface de la gorge peut être recouverte d'une couche isolante d'oxyde.

Cette solution présente cependant certains inconvénients. En effet, la présence de gorges dans le corps semiconducteur rend celui-ci fragile et, lors du sciage, opération nécessaire à la séparation des composants unitaires disposés sur une même plaquette, celle-ci qui se trouve soumise à des contraintes relativement importantes, présente souvent un certain nombre de fêlures, voire même de cassures à des endroits non désirés: d'où un rendement médiocre et un coût élevé, l'opération de sciage ayant lieu après l'élaboration des parties actives des composants. Par ailleurs, le creusage de la gorge est lui-même difficile car l'attaque chimique nécessaire au décapage représente une opération longue nécessitant une protection efficace des régions actives à sauvegarder.

Un autre procédé consiste à remplacer les gorges par des îlots en forme de cloisons contenant en forte concentration des impuretés de type de conduction opposé à celui de certaines couches épitaxiques qu'ils traversent. Dans ces conditions, se trouve créée une jonction P-N d'isolement qui enveloppe les jonctions actives.

Dans bon nombre de cas, quelle que soit la valeur de la tension de claquage susceptible d'être atteinte au niveau des jonctions actives, ledit claquage autour de ces jonctions est précédé par celui produit en surface autour de la jonction d'isolement, ceci étant dû notamment à la mauvaise répartition du champ autour de cette jonction et à la courbure de cette dernière. Cet état de fait peut cependant être corrigé en faisant appel au procédé connu des spécialistes sous le vocable de "RESURF" à partir duquel a pu être réalisé le dispositif décrit dans le brevet français 2 415 370. Les avantages de ce procédé sont liés à un choix adéquat, d'une part du produit N.d de la concentration N de dopage de la couche épitaxique de type opposé à celui des cloisons d'isolement par l'épaisseur d de ladite couche et, d'autre part, de la valeur L représentant la distance entre les îlots d'isolement et l'îlot de prise de contact de cette même couche épitaxique.

Néanmoins, lorsqu'il s'agit de réaliser des transistors de puissance dits à haute tension, ce procédé n'est généralement pas applicable. En effet, ceux-ci sont obtenus le plus souvent à partir d'au moins trois couches épitaxiques successives de types de conduction alternés. Dans ces conditions, la mise en oeuvre du procédé ci-dessus décrit nécessiterait des diffusions de cloisons d'isolement jusqu'à des profondeurs pouvant atteindre 20 à 25/µm au moins. Compte tenu de la durée et des conditions thermiques, physiques et chimiques de telles diffusions, celles-ci entraînent alors des variations de l'épaisseur et de la concentration desdites couches. Par ailleurs, la diffusion profonde des cloisons d'isolement exige une bonne protection de la surface de la couche épitaxique supérieure déposée sur le cristal semiconducteur. Cette protection ne peut être assurée que par une couche épaisse d'oxyde sur laquelle seront déposées par la suite les couches métalliques de prise de contact. En conséquence, pour éviter la détérioration desdites couches métalliques, notamment leur rupture à l'aplomb de la tranche des ouvertures pratiquées dans la couche d'oxyde, la gravure de cette dernière, pour obtenir lesdites ouvertures, devra être du type dit "en pente douce". Or, on sait que cette opération est délicate, fastidieuse et de longue durée.

La présente invention a pour but de permettre l'application du procédé RESURF à la réalisation de transistors haute tension en remédiant aux inconvénients mentionnés ci-dessus.

En effet, la présente invention concerne un procédé de réalisation d'un dispositif semiconducteur selon la revendication 1.

L'élaboration des cloisons latérales d'isolement en deux étapes distinctes permet de réduire les effets, sur l'épaisseur et la concentration des couches épitaxiques, des opérations nécessaires.

C'est ainsi que l'on réduit notablement la durée de diffusion des cloisons d'isolement, diffusion qui, compte tenu des conditions dans lesquelles elle était habituellement pratiquée provoquait une rediffusion transversale et une rediffusion latérale des impuretés contenues dans les couches épitaxiques dont la structure se trouvait alors modifiée.

Par ailleurs, la réduction de la durée de diffusion permet de limiter l'épaisseur de la couche d'oxyde de protection déposée à la surface de la troisième couche épitaxique. Cette amélioration permet d'éviter la gravure dite "en pente douce" lors de l'ouverture des fenêtres dans cette couche d'oxyde.

De préférence, les deux portions des cloisons d'isolement sont obtenues par une diffusion appropriée d'une quantité déterminée d'impuretés donnant le type de conduction choisi.

Avantageusement, pour diminuer la profondeur de la diffusion de la seconde portion des cloisons d'isolement effectuée à partir de la surface extérieure de la troisième couche épitaxique et avant de réaliser ladite diffusion, on creuse dans ladite couche et à partir de cette surface extérieure une gorge située à l'aplomb de la première portion des cloisons d'isolement et de même configuration, la profondeur de ladite gorge restant inférieure à l'épaisseur de ladite troisième couche épitaxique.

De préférence, la profondeur de la gorge creusée dans la troisième couche épitaxique est égale à la moitié de l'épaisseur de ladite couche.

La présente invention concerne également le dispositif selon la revendication 5.

Dans une forme préférentielle de réalisation, les cloisons d'isolement dudit dispositif comportent une gorge creusée dans la troisième couche épitaxique.

La description qui va suivre, en regard des figures décrivant des exemples non limitatifs, fera bien comprendre comment l'invention peut être réalisée.

Les figures 1, 2 et 3 représentent schématiquement et en coupe diverses étapes de mise en oeuvre du procédé selon l'invention dans le but d'obtenir le dispositif illustré par la figure 4.

La figure 5 représente une variante de mise en oeuvre du procédé selon l'invention.

Il est à noter que, sur les figures, les dimensions sont considérablement exagérées et non proportionnées, ceci afin de rendre les dessins plus clairs.

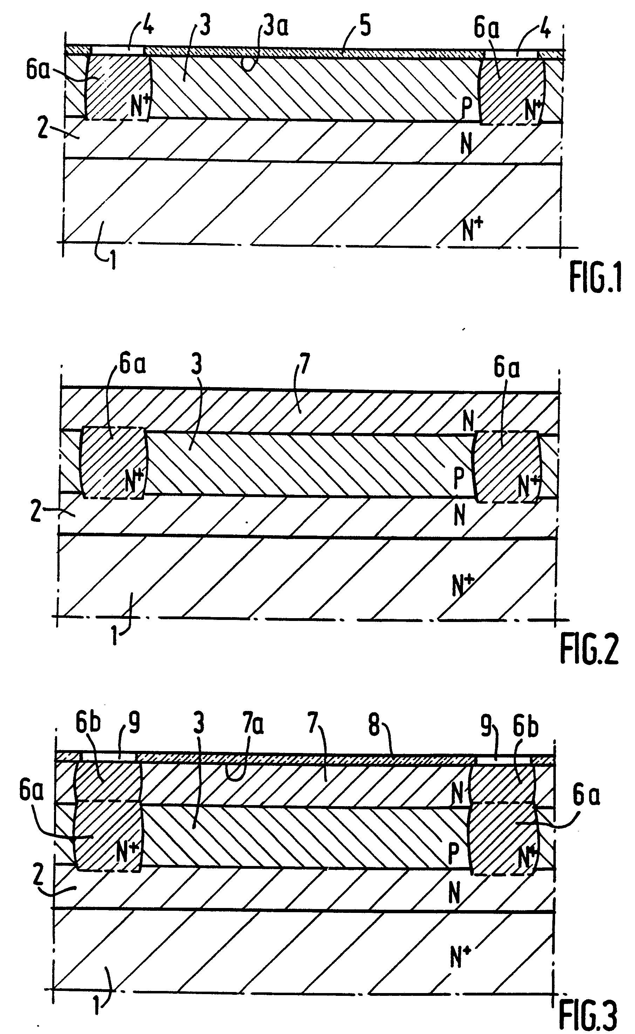

Selon les figures 1 à 3, pour obtenir un dispositif haute tension par le procédé conforme à l'invention, on part d'un substrat semiconducteur 1 d'un premier type de conduction donné, par exemple N, et à forte concentration d'impuretés de ce type.

A la surface de ce substrat 1 faisant fonction de support mécanique, on dépose successivement une première couche épitaxique 2 de même type de conduction que ledit substrat, mais de forte résistivité, puis une deuxième couche épitaxique 3 d'un second type de conduction opposé au premier, donc P.

La couche profonde 2, destinée à former le collecteur du ou des transistors haute tension créés dans le dispositif, aura donc une épaisseur voisine d'une dizaine de μm et une résistivité de 10 - 30 ohm·cm, alors que la couche 3, qui formera la base et dans laquelle sont prévus d'autres éléments, aura une épaisseur de l'ordre d'au moins 10 μm, généralement de l'ordre de 15 μm, et une résistivité de 3 - 8 ohm·cm.

A partir de la surface 3a de ladite couche 3 et par des ouvertures 4 pratiquées dans une couche d'oxyde 5 recouvrant cette surface 3a, on diffuse localement des impuretés de type N dans une concentration importante et à une profondeur au moins égale à l'épaisseur de la couche 3. Les îlots 6a ainsi formés constituent la première portion des cloisons d'isolement conformes à l'invention (figure 1).

Après avoir éliminé la couche d'oxyde 5, l'opération suivante consiste à déposer une troisième couche épitaxique superficielle 7 du premier type de conduction et d'une résistivité de 2-6 ohm·cm. Les conditions thermiques nécessaires au dépôt de cette couche 7 font que les îlots 6a créés préalablement dans la couche intermédiaire 3 évoluent légèrement et pénètrent ainsi plus profondément dans la couche profonde 2 et progressent également dans ladite couche 7 en cours de formation (figure 2).

La dernière phase des opérations nécessaires à la mise en place des cloisons d'isolement consiste à recouvrir la surface 7a de la couche épitaxique 7 d'une nouvelle couche isolante d'oxyde 8 dans laquelle on ouvre ensuite des fenêtres 9 en regard des îlots 6a déjà existants.

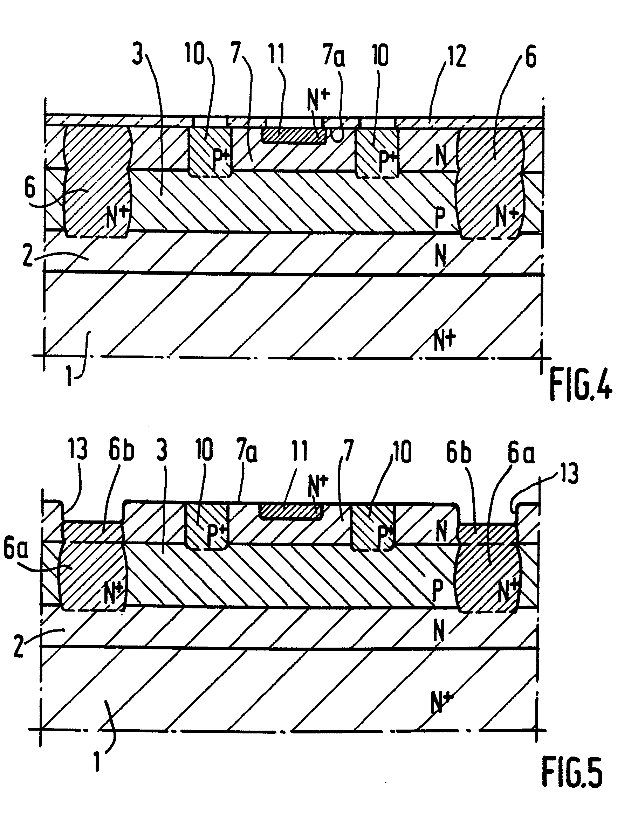

Par ces fenêtres 9, on diffuse alors localement des impuretés de type N qui progressent à travers l'épaisseur de la couche 7 pour atteindre la première portion 6a des cloisons d'isolement, les îlots 6b ainsi créés constituant la seconde portion desdites cloisons (figure 3).

Lorsqu'elles sont reliées entre elles, lesdites portions 6a et 6b forment alors les cloisons d'isolement 6.

On constate que les tolérances d'alignement des îlots 6b par rapport aux îlots 6a ne sont pas critiques, le seul critère indispensable étant que lesdits îlots soient en contact entre eux d'une manière continue.

La suite des opérations nécessaires à la réalisation du dispositif haute tension illustré par la figure 4 fait appel la diffusion localisée des îlots 10 de prise de contact de base, puis la diffusion localisée de l'îlot 11 d'émetteur à travers une nouvelle couche d'oxyde 12. Pour diminuer leur effet sur l'ensemble du dispositif, la diffusion des îlots 6b de type N + et celle des prises de contact 10 peuvent être avantageusement réalisées simultanément.

Dans une variante illustrée par la figure 5, avant de diffuser les îlots 6b de type N +, on creuse dans la couche 7, à partir de sa surface extérieure 7a, des sillons 13 sensiblement en regard des îlots 6a et de profondeur généralement égale à la moitié de l'épaisseur de ladite couche 7.

Cette solution a pour but de diminuer la durée de l'opération de diffusion des îlots 6b et de restreindre ainsi les effets de cette opération sur l'ensemble du dispositif.

Quel que soit le mode de mise en oeuvre choisi, l'épaisseur de la couche intermédiaire 3 est de l'ordre de 15 µm et celle de la troisième couche 7 d'environ 10 µm. La distance qui sépare les cloisons latérales d'isolement 6 des prises de contact de base 10 est au moins égale à l'épaisseur de la zone désertée créée autour de la jonction d'isolement desdites cloisons 6: ce critère, indispensable au bon fonctionnement du dispositif, n'impose aucune contrainte particulière de réalisation compte tenu du niveau de précision auquel sont arrivés les moyens de photogravure.

## Revendications

1. Procédé de réalisation d'un dispositif semiconducteur comportant au moins un transistor bipolaire haute tension, procédé selon lequel sur un substrat (1) on dépose successivement une première couche épitaxique (2) d'un premier type de conduction et une deuxième couche épitaxique (3) du second type de conduction opposé au premier, on forme une zone de contact (10) sur la deuxième couche épitaxique (3), on forme des cloisons latérales (6) d'isolement du premier type de conduction, cloisons qui pénètrent dans la première couche épitaxique après avoir traversé la deuxième couche épitaxique (3), lesdites cloisons latérales (6) entourant un caisson formé dans la deuxième couche épitaxique (3) l'épaisseur et la concentration de dopage de la deuxième couche (3) étant telles que, en appliquant une tension inverse à la jonction pn entre d'une part la deuxième couche épitaxique (3), et d'autre part la première couche épitaxique (2) et les cloisons d'isolement (6), la zone désertée engendrée par cette tension s'étende sur toute l'épaisseur de la deuxième couche épitaxique (3) pour une valeur de ladite tension inférieure à la tension de claquage, la distance séparant les cloisons latérales d'isolement (6) de la zone de contact (10) étant supérieure à l'étendue latérale maximum de la zone désertée à partir des cloisons d'isolement (6) dans la deuxième couche épitaxique (3), caractérisé en ce que sur la deuxième couche épitaxique (3), on dépose une troisième couche épitaxique (7) du premier type de conduction, en ce que les cloisons d'isolement (6) sont élaborées en au moins deux étapes, une première portion (6a) étant créée avant le dépôt de la troisième couche épitaxique (7) et s'étendant sur au moins l'épaisseur totale de la deuxième couche (3), et une seconde portion (6b) étant créée en regard de la première portion (6a), après le dépôt de la troisième couche (7) et à travers l'épaisseur totale de celle-ci, et en ce qu'une partie de la troisième couche épitaxique (7) située à l'intérieur du contour des cloisons d'isolement (6) se trouve isolée électriquement desdites cloisons (6) par l'élaboration de la zone de contact (10) qui entoure ladite partie de troisième couche épitaxique et est séparée desdites cloisons latérales d'isolement (6) par une distance au moins égale à l'épaisseur de la zone désertée créée autour de la jonction d'isolement desdites cloisons (6) et qui pénètre dans le caisson formé dans la deuxième couche épitaxique (3), de même type de conduction, après avoir traversé la troisième couche épitaxique (7).

2. Procédé selon la revendication 1, caractérisé en ce que les deux portions (6a, 6b) des cloisons d'isolement (6) sont obtenues par diffusion d'impuretés du type de conduction approprié.

3. Procédé selon l'une des revendications 1 et 2, caractérisé en ce que, avant de réaliser la seconde portion (6b) ddes cloisons d'isolement (6), on creuse dans la troisième couche épitaxique (7) et à partir de la surface extérieure (7a) de ladite couche une gorge (13) située à l'aplomb de la première portion (6a) des cloisons d'isolement (6) et de même configuration, la profondeur de ladite gorge (13) restant inférieure à l'épaisseur de ladite troisième couche épitaxique (7).

4. Procédé selon la revendication 3, caractérisé en ce que la profondeur de la gorge (13) creusée dans la troisième couche épitaxique (7) est égale à la moitié de l'épaisseur de ladite couche.

5. Dispositif susceptible d'être obtenu par le procédé conforme à l'une des revendications 1 à 4, comportant sur un substrat une première couche épitaxique (2) d'un premier type de conduction, une deuxième couche épitaxique (3) du second type de conduction opposé au premier, une zone de contact (10) sur la deuxième couche épitaxique (3), et des cloisons latérales (6) d'isolement du premier type de conduction, cloisons qui pénètrent dans la première couche épitaxique après avoir traversé la deuxième couche épitaxique (3), lesdites cloisons latérales (6) entourant un caisson formé dans la deuxième couche épitaxique (3) l'épaisseur et la concentration de dopage de la deuxième couche (3) étant telles que, en appliquant une tension inverse à la jonction pn entre d'une part la deuxième couche épitaxique (3), et d'autre part la première couche épitaxique (2) et les cloisons d'isolement (6), la zone désertée engendrée par cette tension s'étende sur toute l'épaisseur de la deuxième couche épitaxique (3) pour une valeur de ladite tension inférieure à la tension de claquage, la distance séparant les cloisons latérales d'isolement (6) de la zone de contact (10) étant supérieure à l'étendue latérale maximum de la zone désertée à partir des cloisons d'isolement (6) dans la deuxième couche épitaxique (3), caractérisé en ce que sur la deuxième couche épitaxique (3), le dispositif comporte encore un troisième couche épitaxique (7) du premier type de conduction, en ce que lesdites cloisons d'isolement (6) comportent deux îlots (6a, 6b) situés à l'aplomb l'un de l'autre, de même premier type de conduction et en contact entre eux, le deuxième (6b) de ces îlots traversant la troisième couche épitaxique (7), et en ce qu'une partie de la troisième couche épitaxique (7) située à l'intérieur du contour des cloisons d'isolement (6), est isolée électriquement desdites cloisons (6) par la zone de contact (10) qui entoure ladite partie de troisième couche épitaxique et est séparée desdites cloisons d'isolement (6) par une distance au moins égale à l'épaisseur de la zone désertée créée autour de la jonction d'isolement desdites cloisons (6) et qui pénètre dans le caisson formé dans la deuxième couche épitaxique (3), de même type de conduction, à travers la troisième couche épitaxique (7).

6. Dispositif selon la revendication 5, caractérisé en ce que les cloisons d'isolement (6) comportent une gorge (13) creusée dans la troisième couche épitaxique (7).

**Patentansprüche**

1. Verfahren zum Herstellen einer Halbleiteranordnung mit mindestens einem bipolaren Hochspannungstransistor, wobei nacheinander auf einem Substrat (1) eine erste Epitaxialschicht (2) eines ersten Leitungstyps und eine zweite Epitaxialschicht (3) vom zweiten, dem ersten entgegengesetzten Leitungstyp niedergeschlagen werden, wobei auf der zweiten Epitaxialschicht (3) eine Kontaktzone (10) sowie laterale isolierende Trennwände (6) vom ersten Leitungstyp gebildet werden, die nach dem Durchgang durch die zweite Epitaxialschicht (3) in die erste Epitaxialschicht eindringen, wobei die genannten lateralen Trennwände (6) eine in der zweiten Epitaxialschicht (3) gebildete Insel umgeben, wobei die Dicke und die Dotierungskonzentration der zweiten Schicht (3) derart sind, dass beim Zuführen einer Sperrspannung zu dem PN- Übergang zwischen der zweiten Epitaxialschicht (3) einerseits und der ersten Epitaxialschicht (2) und den isolierenden Trennwänden (6) andererseits die durch diese Spannung erhaltene Erschöpfungszone sich über die ganze Dicke der zweiten Epitaxialschicht (3) erstreckt und zwar für einen Wert der genannten Spannung, der kleiner ist als die Durchbruchspannung, wobei der Abstand zwischen den lateralen isolierenden Trennwänden (6) und der Kontaktzone (10) grösser ist als die maximale laterale Ausdehnung der Erschöpfungszone, ausgehend von den Trennwänden (6) in der zweiten Epitaxialschicht (3), dadurch gekennzeichnet, dass auf der zweiten Epitaxialschicht (3) eine dritte Epitaxialschicht (7) vom ersten Leitungstyp niedergeschlagen wird, dass die Trennwände (6) in wenigstens zwei Herstellungsstufen angebracht werden, wobei ein erster Teil (6a) vor dem Niederschlagen der dritten Epitaxialschicht (7) gebildet wird und sich über wenigstens die ganze Dicke der zweiten Schicht (3) erstreckt und wobei ein zweiter Teil (6b) gegenüber dem ersten Teil (6a) nach dem Niederschlagen der dritten Schicht (7) gebildet wird und sich über die ganze Dicke derselben erstreckt und dass ein Teil der dritten Epitaxialschicht (7), der innerhalb der Trennwände (6) liegt, gegenüber den genannten Wänden (6) isoliert ist und zwar durch die Kontaktzone (10), die den genannten Teil der dritten Epitaxialschicht umgibt und von den genannten lateralen isolierenden Trennwänden (6) getrennt ist über einen Abstand, der wenigstens gleich der Dicke der Erschöpfungszone um den Isolierungsübergang der genannten Wände (6) ist und die nach dem Durchgang durch die dritte Epitaxialschicht (7) in die in der zweiten Epitaxialschicht (3) desselben Leitungstyps gebildete Insel eindringt.

2. Verfahren nach Anspruch 1, dadurch gekennzeichnet, dass die zwei Teile (6a, 6b) der isolierenden Trennwände (6) durch Diffusion von Verunreinigungen vom geeigneten Leitungstyp erhalten worden sind.

3. Verfahren nach einem der Ansprüche 1 und 2, dadurch gekennzeichnet, dass bevor der zweite Teil (6b) der isolierenden Trennwände (6) verwirklicht ist, in der dritten Epitaxialschicht (7) ausgehend von der Aussenoberfläche (7a) der genannten Schicht eine Rille (13) angebracht wird, die senkrecht unter dem ersten Teil (6a) der isolierenden Trennwände (6) liegt und dieselbe Konfiguration hat, wobei die Tiefe der genannten Rille (13) kleiner bleibt als die Dicke der genannten dritten Epitaxialschicht (7).

4. Verfahren nach Anspruch 3, dadurch gekennzeichnet, dass die Tiefe der Rille (13) in der dritten Epitaxialschicht (7) der halben Dicke der genannten Schicht entspricht.

5. Nach dem Verfahren nach einem der Ansprüche 1 bis 4 erhaltene Anordnung, bei der auf einem Substrat eine erste Epitaxialschicht (2) eines ersten Leitungstyps, eine zweite Epitaxialschicht (3) vom zweiten, dem ersten entgegengesetzten Leitungstyp (3), eine Kontaktzone (10) auf der zweiten Epitaxialschicht (3) und laterale isolierende Trennwände (6) vom ersten Leitungstyp vorhanden sind, wobei die Trennwände nach dem Durchgang durch die zweite Epitaxialschicht (3) in die erste Epitaxialschicht eindringen, wobei die genannten lateralen Trennwände eine Insel in der zweiten Epitaxialschicht (3) umgeben, wobei die Dicke und die Dotierungskonzentration der zweiten Schicht (3) derart sind, dass beim Zuführen einer Sperrspannung zu dem PN-Übergang zwischen der zweiten Epitaxialschicht (3) einerseits und der ersten Epitaxialschicht (2) und den isolierenden Trennwänden (6) andererseits, die durch diese Spannung angeregte Erschöpfungszone sich über die ganze Dicke der zweiten Epitaxialschicht (3) erstreckt für einen Wert der genannten Spannung, der niedriger ist als die Durchbruchspannung, wobei der Abstand zwischen den isolierenden lateralen Trennwänden (6) und der Kontaktzone (10) grösser ist als die maximale laterale Ausdehnung der Erschöpfungszone, ausgehend von den isolierenden Trennwänden (6) in der zweiten Epitaxialschicht (3), dadurch gekennzeichnet, dass die Anordnung auf der zweiten Epitaxialschicht (3) ebenfalls eine dritte Epitaxialschicht (7) vom ersten Leitungstyp aufweist und dass die genannten isolierenden Trennwände (6) zwei Teile (6a, 6b) aufweisen, die senkrecht untereinander liegen und von demselben ersten Leitungstyp und miteinander verbunden sind, wobei die zweite (6b) dieser Teile durch die dritte Epitaxialschicht (7) hindurchgeht und dass ein Teil der dritten Epitaxialschicht (7), der innerhalb der isolierenden Trennwände (6) liegt, gegenüber den genannten Trennwänden (6) elektrisch isoliert ist und zwar durch die Kontaktzone (10), die den genannten Teil der dritten Epitaxialschicht umgibt und von den genannten isolierenden Trennwänden (6) in einem Abstand liegt, der der Dicke der um den Isolierübergang der genannten Trennwände (6) gebildeten Erschöpfungszone wenigstens entspricht und die durch die dritte Epitaxialschicht (7) hindurch in die in der zweiten Epitaxialschicht (3) gebildete Insel desselben Leitungstyps eindringt.

6. Anordnung nach Anspruch 5, dadurch gekennzeichnet, dass die isolierenden Trennwände (6) eine in der dritten Epitaxialschicht (7) vorgesehene Rille (13) aufweisen.

## Claims

1. A method of manufacturing a semiconductor device comprising at least one high-voltage bipolar transistor, according to which method there are successively deposited on a substrate (1) a first epitaxial layer (2) of a first conductivity type and a second epitaxial layer (3) of the second conductivity type opposite to the first type, a contact zone (10) is formed on the second epitaxial layer (3) and lateral isolating separation walls (6) of the first conductivity type are formed, these separation walls penetrating into the first epitaxial layer after having traversed the second epitaxial layer (3), the said lateral separation walls (6) surrounding an island formed in the second epitaxial layer (3), the thickness and the doping concentration of the second layer (3) being such that, when an inverse voltage is applied to the pn-junction between on the one hand the second epitaxial layer (3) and on the other hand the first epitaxial layer (2) and the isolating separation walls (6), the depleted zone produced by this voltage extends throughout the thickness of the second epitaxial layer (3) for a value of the said voltage lower than the breakdown voltage, the distance between the lateral isolating separation walls (6) and the contact zone (10) being larger than the maximum lateral extent of the depleted zone from the isolating separation walls (6) in the second epitaxial layer (3), characterized in that a third epitaxial layer (7) of the first conductivity type is deposited on the second epitaxial layer (3), in that the isolating separation walls (6) are manufactured in at least two stages, a first portion (6a) being formed before the deposition of the third epitaxial layer (7) and extending through at least the whole thickness of the second layer (3), amd a second portion (6b) being formed opposite to the first portion (6a) after the deposition of the third layer (7) and throughout the thickness of the latter, and in that a part of the third epitaxial layer (7) situated within the contour of the isolating separation walls (6) is electrically insulated from the said separation walls (6) by the formation of the contact zone (10) which surrounds the said part of the third epitaxial layer and is separated from the said lateral isolating separation walls (6) by a distance at least equal to the thickness of the depleted zone formed around the isolating junction of the said separation walls (6), and penetrates into the islands formed in the second epitaxial layer (3) of the same conductivity type after having traversed the third epitaxial layer (7).

2. A method as claimed in Claim 1, characterized in that the two portions (6a, 6b) of the isolating separation walls (6) are obtained by diffusion of impurities of the suitable conductivity type.

3. A method as claimed in any one of Claims 1 and 2, characterized in that, before the second portion (6b) of the isolating separation walls (6) is formed a groove (13) situated at right angles to the first portion (6a) of the isolating separation walls (6) and having the same configuration is formed in the third epitaxial layer (7) and from the outer surface (7a) of the said layer, the depth of the said groove (13) remaining smaller than the thickness of the said third epitaxial layer (7).

4. A method as claimed in Claim 3, characterized in that the depth of the groove (13) provided in the third epitaxial layer (7) is equal to half the thickness of the said layer.

5. A device which can be obtained by means of the method claimed in any one of Claims 1 to 4, which comprises on a substrate a first epitaxial layer (2) of a first conductivity type, a second epitaxial layer (3) of the second conductivity type opposite to the first type, a contact zone (10) on the second epitaxial layer (3) and lateral isolating separation walls (6) of the first conductivity type, which penetrate into the first epitaxial layer after having traversed the second epitaxial layer (3), the said lateral separation walls (6) surrounding an island formed in the second epitaxial layer (3), the thickness and the doping concentration of the second layer (3) being such that, when an inverse voltage is applied to the pn-junction between on the one hand the second epitaxial layer (3) and on the other hand the first epitaxial layer (2) and the isolating separation walls (6), the depleted zone produced by this voltage extends throughout the thickness of the second epitaxial layer (3) for a value of the said voltage smaller than the breakdown voltage, the distance between the lateral isolating separation walls (6) and the contact zone (10) being larger than the maximum lateral extent of the depleted zone from the isolating separation walls (6) in the second epitaxial layer (3), characterized in that on the second epitaxial layer (3) the device further comprises a third epitaxial layer (7) of the first conductivity type, in that the said isolating separation walls (6) comprise two islands (6a, 6b) situated at right angles to each other having the same first conductivity type and being in contact with each other, the second (6b) of these islands traversing the third epitaxial layer (7), and in that a part of the third epitaxial layer (7) situated within the contour of the isolating separation walls (6) is electrically isolated from the said separation walls (6) by the contact zone (10), which surrounds the part of the third epitaxial layer and is separated from the said isolating separation walls (6) by a distance at least equal to the thickness of the depleted zone produced around the isolating junction of the said separation walls (6) and penetrates into the island formed in the second epitaxial layer (3) of the same conductivity type through the third epitaxial layer (7).

6. A device as claimed in Claim 5, characterized in that the isolating separation walls (6) comprise a groove (13) provided in the third epitaxial layer (7).

FIG.1

FIG.2

FIG.3

FIG.4

FIG.5